# EUROPEAN PATENT APPLICATION

(11) **EP 4 608 098 A1**
(43) Date of publication of application: **27.08.2025**
(21) Application number: 25158942.0
(22) Date of filing: 19.02.2025
(51) Int. Cl.: H10F 39/12, H10F 39/00

(54) **PIXELS OF IMAGE SENSOR AND THE IMAGE SENSOR**

(30) Priority: 22.02.2024 KR 20240025462
(71) Applicant: Samsung Electronics Co., Ltd., Suwon-si, Gyeonggi-do 16677 (KR)
(72) Inventor: SHIN, Seungho, 16677 Suwon-si (KR); PARK, Soeun, 16677 Suwon-si (KR); PARK, Joongseok, 16677 Suwon-si (KR); PARK, Cheonho, 16677 Suwon-si (KR); BAE, Hyungjin, 16677 Suwon-si (KR); LEE, Hongsuk, 16677 Suwon-si (KR); LIM, Moosup, 16677 Suwon-si (KR)
(74) Representative: Marks & Clerk LLP

(57) **Abstract**

An image sensor including a plurality of pixels and an analog to digital circuit connected to each of the plurality of pixels. At least one pixel among the plurality of pixels includes a first area including a first floating diffusion node and a first photo diode, a second area including a second floating diffusion node and a second photo diode having a size less than a size of the first photo diode, and a third area configured to physically separate the first area and the second area, and a switch included in the third area and configured to block movement of electrons emitted from the first floating diffusion node in the first area to the second floating diffusion node in the second area.

## Description

### BACKGROUND

Aspects of the inventive concept relate to pixels of an image sensor and the image sensor, and more particularly, to pixels, which include a plurality of photo diodes with different sensitivities to light, capable of preventing deterioration of adjacent photo diodes due to electron saturation of each of the plurality of photo diodes.

Split photo diode technology is applied to pixels of recently developed image sensors to generate high-resolution images. Split photo diode technology is mainly applied to corner pixels of image sensors. The pixels of image sensors to which split photo diode technology is applied include a plurality of photo diodes divided to match a shape of a pixel array.

However, because the plurality of photo diodes have different sensitivities to light, the order of saturation of the plurality of photo diodes is also different, and a firstly saturated photo diode affects adjacent photo diodes. For example, the firstly saturated photo diode transfers electrons to the adjacent photo diodes, causing a problem of deterioration of the adjacent photo diodes. Specifically, the plurality of photo diodes may have different sizes. When a switch that controls electron transfer of the plurality of photo diodes is located in a large-sized photo diode, a floating diffusion node is located in the large-sized photo diode, and thus, there is a problem that affects the adjacent photo diodes.

### SUMMARY

Aspects of the inventive concept provide pixels that physically separate a plurality of photo diodes included in the pixels of an image sensor and prevent deterioration of adjacent photo diodes due to saturation of any photo diode.

In addition, aspects of the inventive concept provide pixels that suppress transfer of electrons from a firstly saturated photo diode to adjacent photo diodes.

According to an aspect of the inventive concept, there is provided an image sensor comprising: a substrate comprising a first surface and a second surface opposing the first surface; a first area comprising a first floating diffusion node (FD), a second FD, and a first photo diode (PD); a second area comprising a third FD and a second PD having a size less than a size of the first PD; a switch connected to the second FD and the third FD; a gain control transistor connected to the first FD and the second FD; a first deep trench isolation separating the first PD and the second PD; a first transfer transistor configured to transfer photoelectric charges generated by the first PD to the first FD; and a second transfer transistor configured to transfer photoelectric charges generated by the second PD to the third FD, wherein a portion of the switch vertically overlapping with the first PD is equal or greater than 0% and less than 50% of a whole area of the switch in a plan view.

According to an aspect, there is provided an image sensor comprising: a substrate comprising a first surface and a second surface opposing the first surface; a plurality of photo diodes (PDs) disposed in a first direction and a second direction perpendicular to the first direction, the plurality of PDs including a first PD and a second PD having a size less than a size of the first PD; a first floating diffusion node (FD); a second FD; a third FD; a first switch connected to the second FD and the third FD; a gain control transistor connected to the first FD and the second FD; a first deep trench isolation separating the first PD and the second PD; a first transfer transistor configured to transfer photoelectric charges generated by the first PD to the first FD; and a second transfer transistor configured to transfer photoelectric charges generated by the second PD to the third FD, wherein the second PD is directly disposed diagonally from the first PD in a plan view, wherein a portion of the first switch vertically overlapping with the first PD is equal or greater than 0% and less than 50% of a whole area of the first switch in a plan view.

According to an aspect of the inventive concept, there is provided an image sensor comprising a plurality of pixels; and an analog to digital circuit connected to each of the plurality of pixels, wherein at least one pixel among the plurality of pixels includes a first area comprising a first floating diffusion node and a first photo diode, a second area comprising a second floating diffusion node and a second photo diode having a size less than a size of the first photo diode, a third area configured to physically separate the first area and the second area, and a switch included in the third area and configured to block movement of electrons emitted from the first floating diffusion node in the first area to the second floating diffusion node in the second area.

According to another aspect of the inventive concept, there is provided an image sensor comprising a plurality of pixels; and an analog to digital circuit connected to each of the plurality of pixels, wherein at least one pixel among the plurality of pixels includes a first area comprising a first floating diffusion node and a first photo diode, a second area comprising a second floating diffusion node and a second photo diode having a size less than a size of the first photo diode, a third area comprising a switch configured to block movement of electrons emitted from a first floating diffusion node in the first area to a second floating diffusion node in the second area by physically separating the first area and the second area, and a fourth area doped with a P-type semiconductor and configured to prevent the electrons from being transferred from the first area to the second area.

According to another aspect of the inventive concept, there is provided an image sensor including a plurality of pixels; and an analog to digital circuit connected to each of the plurality of pixels, wherein at least one pixel among the plurality of pixels includes a first area comprising a first floating diffusion node and a first photo diode, a second area comprising a second floating diffusion node and a second photo diode having a size less than a size of the first photo diode and being physically spaced apart from the first area, a switch configured to control connection between a first floating diffusion node in the first area and a second floating diffusion node in the second area, and an impurity area configured to suppress transfer of electrons between the first area and the second area, and wherein the impurity area includes a first impurity area located in the first area and the second area and configured to suppress movement of the electrons to the second floating diffusion node, and a second impurity area located in the first area and configured to suppress movement of the electrons to the second floating diffusion node.

The following features may apply to any of the above described aspects.

The first area and second area may belong to a pixel of the image sensor. The switch, gain control transistor, first deep trench isolation, first transfer transistor, and second transfer transistor may belong to the pixel.

The second area may be disposed diagonally from the first area in an array of pixels of the image sensor. The array of pixels comprises the pixel including the first area and second area.

The image sensor may further comprise a third area. The third area may be part of the pixel including the first area and second area.

In some embodiments, the image sensor comprises a third area (which may be part of the pixel) comprising a fourth FD and a third PD having substantially the same size as the size of the first PD, wherein the third area is disposed adjacent to the first area in a second direction, and wherein the switch is disposed between the first PD and the third PD in the plan view.

The first area and the second area may be areas of the substrate.

The substrate may be a semiconductor substrate.

In some embodiments, the first transfer transistor extends into the substrate. Similarly, the second transfer transistor extends into the substrate.

In some embodiments, the image sensor further comprises a plurality of switches disposed in the first direction and the second direction. Each of the plurality of switches may be associated with a different pixel of the image sensor and may form a connection between areas containing separate photo diodes.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram of an image sensor according to an embodiment;
FIG. 2 is a diagram for explaining a pixel including corner pixels, according to an embodiment;
FIG. 3A is a diagram for explaining a pixel including a first photo diode and a second photo diode, according to an embodiment;
FIG. 3B is a circuit diagram of the pixel including the first photo diode and the second photo diode, according to an embodiment;
FIGS. 4A to 4C are diagrams for explaining available forms of a pixel including photo diodes, according to an embodiment;
FIG. 5 is a diagram for explaining a pixel when a third area exists in a second stack according to an embodiment;
FIG. 6 is a diagram for explaining a pixel including an impurity area, according to an embodiment;
FIG. 7 is a diagram for explaining a pixel including a plurality of impurity areas, according to an embodiment; and
FIG. 8 is a diagram of a pixel configured with a certain distance between a large photo diode and an impurity area, according to an embodiment.

### DETAILED DESCRIPTION OF THE EMBODIMENTS

Hereinafter, the embodiments of the inventive concept will be described along with the attached drawings. Hereinafter, details such as detailed configuration and structure are provided to help readers understand the embodiments of the inventive concept. Therefore, the embodiments described herein may be changed or modified in various ways without departing from the embodiments of the inventive concept.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

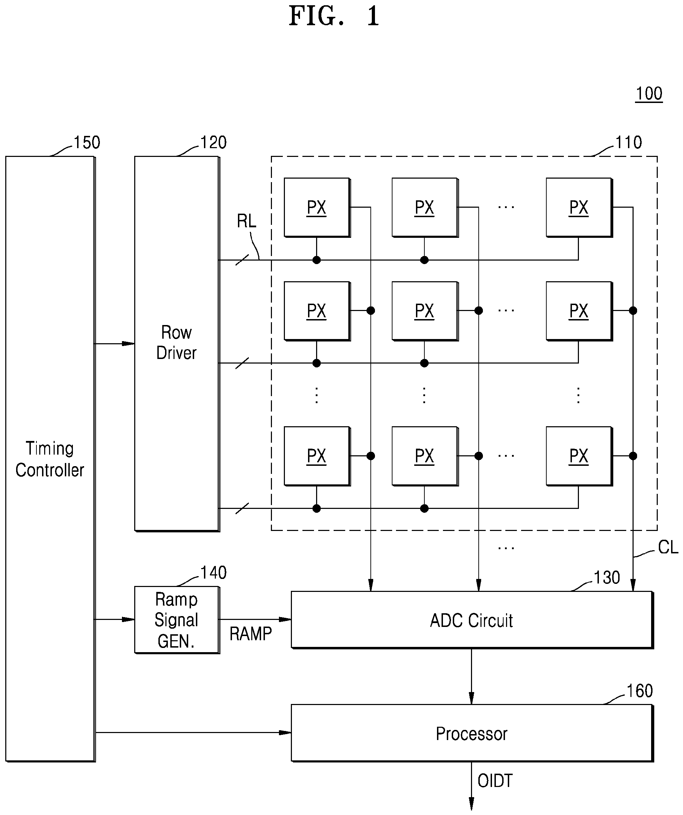

FIG. 1 is a block diagram of an image sensor 100 according to an embodiment.

Referring to FIG. 1, the image sensor 100 may include a pixel array 110, a row driver 120, an analog-to-digital conversion circuit 130 (hereinafter referred to as an ADC circuit), a ramp signal generator 140, and a timing controller 150, and a processor 160. The pixel array 110 may be formed on a substrate (e.g. a semiconductor substrate).

The pixel array 110 includes a plurality of pixels PX arranged in rows and columns, and a plurality of row lines RL and a plurality of column lines CL connected to the plurality of pixels PX. Each of the pixels PX of the pixel array 110 according to an embodiment may include a corner pixel. The corner pixel according to an embodiment may comprise a photo diode having a relatively small size in the pixel PX where a plurality of photo diodes are present. Each of the plurality of pixels PX according to an embodiment may include at least one photoelectric conversion device (or referred to as a photosensitive device). The photoelectric conversion device may detect light and convert the detected light into photoelectric charges. For example, the photoelectric conversion device may be the photosensitive device including an organic material or an inorganic material, such as an inorganic photo diode, an organic photo diode, a perovskite photo diode, a photo transistor, a photo gate, or a pinned photo diode. In an embodiment, each of the plurality of pixels PX may include a plurality of photoelectric conversion devices. A plurality of photosensitive devices may be disposed on the same layer, or may be stacked in a direction perpendicular to each other.

A micro lens for focusing light may be disposed on each of the plurality of pixels PX or on each of a plurality of pixel groups including the adjacent pixels PX. Each of the plurality of pixels PX may detect light in a specific spectrum area from light received through the micro lens.

The pixel array 110 according to an embodiment may include pixels PX having a red, green, and blue (RGB) pattern or a red, green, blue, and white color (RGBWC) pattern. For example, the pixel array 110 may include a red pixel that converts light in a red spectrum area into an electrical signal, a green pixel that converts light in a green spectrum area into an electrical signal, and a blue pixel that converts light in a blue spectrum area into an electrical signal. In addition, the pixel array 110 may include a white pixel that converts light having all components of the red spectrum area, the green spectrum area, and the blue spectrum area into an electrical signal. A color filter that transmits light in a specific spectrum area may be disposed on each of the plurality of pixels PX. However, aspects of the inventive concept are not limited thereto, and the pixel array 110 may include pixels that convert light in spectrum areas other than the red spectrum area, the green spectrum area, and the blue spectrum area into electrical signals.

The plurality of pixels PX according to an embodiment may have a multi-layer structure. The pixel PX of the multi-layer structure may include stacked photosensitive devices that convert light in different spectrum areas into electrical signals, and electrical signals corresponding to different colors may be generated from the photosensitive devices. In other words, electrical signals corresponding to a plurality of colors may be output from one pixel PX.

In addition, the pixel array 110 may include the plurality of row lines RL and the plurality of column lines CL. The plurality of row lines RL may each extend in a row direction and be respectively connected to the pixels PX arranged in the same row. For example, the plurality of row lines RL may respectively transmit control signals output from the row driver 120 to devices provided in the pixel PX, for example, a plurality of transistors.

The plurality of column lines CL may each extend in a column direction and be respectively connected to the pixels PX disposed in the same column. Each of the plurality of column lines CL may transmit a pixel signal, such as a reset signal and a sensing signal, output from the pixels PX of the pixel array 110 in row units to the ADC circuit 130.

The row driver 120 may generate control signals for driving the pixel array 110 by the control of the timing controller 150, and respectively provide the control signals to the plurality of pixels PX of the pixel array 110 through the plurality of row lines RL. The row driver 120 may control the plurality of pixels PX of the pixel array 110 to detect light incident simultaneously or in row units. In addition, the row driver 120 may select the pixels PX in row units or at least two row units from among the plurality of pixels PX, and control the selected pixels PX to output pixel signals through the plurality of column lines CL.

The ADC circuit 130 may receive a plurality of pixel signals read out from the plurality of pixels PX in a row selected by the row driver 120 from among the plurality of pixels PX, and convert the plurality of pixel signals into a plurality of pixels that are digital data.

The ADC circuit 130 may convert the plurality of pixel signals received from the pixel array 110 through the plurality of column lines CL into the digital data based on a ramp signal RAMP from the ramp signal generator 140, thereby generating and outputting first image data, for example, raw image data, in row units.

The ADC circuit 130 may include a plurality of ADCs respectively corresponding to the plurality of column lines CL, and each of the plurality of ADCs may compare a pixel signal received through the corresponding column line CL with the ramp signal RAMP, and generate a pixel value based on comparison results. For example, the ADC circuit 130 may remove the reset signal from the sensing signal by using a CDS method and generate a pixel value indicating the amount of light detected at the pixel PX.

The ramp signal generator 140 may generate the ramp signal RAMP that increases or decreases at a certain inclination, and may provide the ramp signal RAMP to the ADC circuit 130.

The timing controller 150 may control the timing of other components of the image sensor 100, such as the row driver 120, the ADC circuit 130, the ramp signal generator 140, and the processor 160. The timing controller 150 may provide a timing signal indicating operation timing of each of the row driver 120, the ADC circuit 130, the ramp signal generator 140, and the processor 160.

The processor 160 may process data on the plurality of pixel values input from the ADC circuit 130. The processor 160 may perform image quality compensation, binning, downsizing, etc. on image data. Accordingly, image-processed output image data OIDT may be generated and output in certain units.

For example, the processor 160 may process the image data by color. For example, when the image data includes red, green, and blue pixel values, processor 160 may process red, green, and blue pixels in parallel or in series. In addition, the processor 160 may process the image data by color in parallel and may include a plurality of processing circuits.

The processor 160 may generate the output image data OIDT with a reduced data size by performing a binning method according to an embodiment, which will be described below.

The output image data OIDT may be output to an external processor, for example, an application processor, and the application processor may store, image-process, or display the output image data OIDT.

According to an embodiment, the image sensor 100 may analog-sum the plurality of pixel signals in a slash direction, a back slash direction, a diamond shape, a square shape, or an isosceles triangle shape while simultaneously reading out the plurality of pixel signals. The image data may be generated according to the analog summation method described above, and the processor 160 may perform binning on the image data. Accordingly, the amount of the output image data OIDT may be reduced, and the occurrence of false colors and zigzag noise due to a difference in sampling frequencies may be alleviated.

The image sensor 100 may be mounted on an electronic device having an image or light sensing function. For example, the image sensor 100 may be mounted on an electronic device such as a camera, a smartphone, a wearable device, Internet of Things (IoT) device, a home appliance, a tablet personal computer (PC), a personal digital assistant (PDA), a portable multimedia player (PMP), navigation, a drone, and an advanced driver assistance system (ADAS). In addition, the image sensor 100 may be mounted on an electronic device provided as a component in a vehicle, furniture, a manufacturing facility, a door, and various measurement devices.

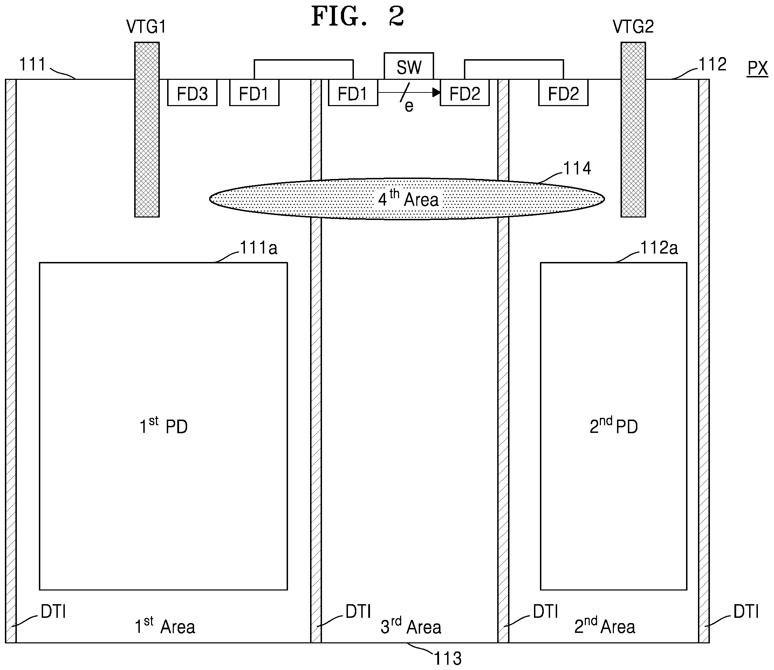

FIG. 2 is a diagram for explaining the pixel PX including a corner pixel according to an embodiment.

Referring to FIG. 2, the pixel PX according to an embodiment may include a first area 111, a second area 112, and a third area 113. According to an embodiment, the first area 111, the second area 112, and the third area 113 may be spaced apart from a plurality of areas of the pixel PX. For example, the pixel PX may be separated by deep trench isolation (DTI) and divided into the first area 111, the second area 112, and the third area 113. In addition, the pixel PX according to an embodiment may include a fourth area. The first area 111, second area 112, and third area 113 may be areas of a substrate. Each of these areas may be separated by the deep trench isolation (DTI), which extends between a first surface and a second surface of the substrate. One of the deep trench isolation (DTI) structures may also separate the switch from the first photo diode 111a. For example, the first area 111 and the second area 112 may be separated by a first DTI and a second DTI, where the second DTI may be located closer to the first area 111 than the first DTI and may be disposed between the first PD 111a and a switch SW. The pixel PX may include a substrate comprising a first surface and a second surface opposing the first surface. For example, the first surface may refer to the topmost portion of the pixel PX, while the second surface may refer to the bottommost portion of the pixel PX. The DTI is in contact with the first surface of the substrate and the second surface of the substrate. For example, the first DTI and the second DTI are in contact with the first surface of the substrate and the second surface of the substrate.

The first area 111 according to an embodiment may include a first photo diode 111a. In addition, the second area 112 according to an embodiment may include a second photo diode 112a having a size less than that of the first photo diode 111a. The first area 111 and the second area 112 according to an embodiment may be physically divided. For example, the first area 111 and the second area 112 may be physically divided by the third area 113. The third area 113 according to an embodiment may be located between the first area 111 and the second area 112.

The size of the first photo diode 111a according to an embodiment may be greater than that of the second photo diode 112a. For example, the second photo diode 112a may be configured to have a size value less than that of the first photo diode 111a. The second photo diode 112a according to an embodiment may reach a saturation state more quickly than the first photo diode 111a. For example, the second photo diode 112a having the size less than that of the first photo diode 111a may reach the saturation state more quickly due to the same amount of light charges. The saturation state according to an embodiment means a state in which a photo diode accommodates the maximum amount of light charges. For example, when the first photo diode 111a and the second photo diode 112a each reach the saturation state, the first photo diode 111a and the second photo diode 112a may no longer accommodate light charges.

The first area 111 and the second area 112 according to an embodiment may include a first vertical structure transfer gate VTG1 and a second vertical structure transfer gate VTG2, respectively. For example, the first area 111 may include the first vertical structure transfer gate VTG1, and the second area 112 may include the second vertical structure transfer gate VTG2. The first vertical structure transfer gate VTG1 according to an embodiment may transfer electrons e generated in the first photo diode 111a to a first floating diffusion node FD1. The second vertical structure transfer gate VTG2 according to an embodiment may transfer electrons e generated in the second photo diode 112a to a second floating diffusion node FD2. The first area 111 and the second area 112 according to an embodiment include the first vertical structure transfer gate VTG1 and the second vertical structure transfer gate VTG2, respectively, and thus, the first photo diode 111a and the second photo diode 112a may each accommodate the maximum amount of light charges despite the DTI. The first vertical structure transfer gate VTG1 is the gate terminal of a first transfer transistor LTG included in the first photo diode 111a. The second vertical structure transfer gate VTG2 is the gate terminal of a second transfer transistor STG included in the second photo diode 112a.
The third area 113 according to an embodiment may include the first floating diffusion node FD1, the second floating diffusion node FD2, and a switch SW. For example, the first area 111 and the third area 113 may be connected by the first floating diffusion node FD1, and the second area 112 and the third area 113 may be connected by the second floating diffusion node FD2. The switch SW according to an embodiment may be located in the third area 113 and may prevent electrons e from being transferred from the first floating diffusion node FD1 to the second floating diffusion node FD2. For example, the switch SW may block the transfer of the electrons e to the second photo diode 112a due to saturation of the first photo diode 111a, and prevent deterioration of the second photo diode 112a. In embodiments (including in FIG. 2), an isolation in the plan view between the switch SW and the first photo diode 111a may be achieved. More specifically, a portion of the switch vertically overlapping with the first photo diode 111a is equal or greater than 0% and less than 50% of a whole area of the switch SW in the plan view. In the example of FIG. 2, a portion of the switch vertically overlapping with the first photo diode 111a may be equal to 0%. In some embodiments, in a plan view, the switch SW may have a portion vertically overlapping the first PD 111a. For example, the portion of the switch SW vertically overlapping the first PD 111a may account for 0% or more but less than 50% of the whole area of the switch SW in the plan view. Alternatively, the portion of the switch SW vertically overlapping the first PD 111a may account for 0% or more but less than 20% of the whole area of the switch SW in the plan view.

The first floating diffusion node FD1 according to an embodiment may transfer the electrons e from the first area 111 to the second area 112. The switch SW according to an embodiment may block the transfer of the electrons e from the first floating diffusion node FD1 to the second floating diffusion node FD2, thereby preventing the electrons e from being transferred to the second area 112.

The first floating diffusion node FD1 according to an embodiment may be a contact point between the first area 111 and the third area 113. In addition, the second floating diffusion node FD2 according to an embodiment may be a contact point between the second area 112 and the third area 113. The switch SW according to an embodiment may block connection between the first floating diffusion node FD1 and the second floating diffusion node FD2.

The switch SW according to an embodiment may control the connection between the first floating diffusion node FD1 in the first area 111 and the second floating diffusion node FD2 in the second area 112. For example, when the first photo diode 111a is saturated, the switch SW may be blocked (e.g. opened), and the electrons e may not be transferred from the first area 111 to the second area 112. Additionally, when the second photo diode 112a is saturated, the switch SW may be blocked (e.g., opened), and the electrons e may not be transferred from the second area 112 to the first area 111.

The fourth area 114 according to an embodiment may be configured to prevent the electrons e from being transferred from the first area 111 to the second area 112. For example, the fourth area 114 may be a barrier area. The fourth area 114 according to an embodiment may be configured to exist across the first area 111, the second area 112, and the third area 113. For example, the fourth area 114 may be configured to exist across the first area 111, the second area 112, and the third area 113. The fourth area 114 according to an embodiment may be doped with a P-type semiconductor. For example, the fourth area 114 may be doped with the P-type semiconductor to prevent the electrons e from being transferred from the first area 111 to the second area 112.

Although not shown in FIG.2, the third area 113 may comprise a third photo diode having a size less than the size of the first photo diode. In this case, the switch SW may be disposed between the second PD and the third PD in the plan view.

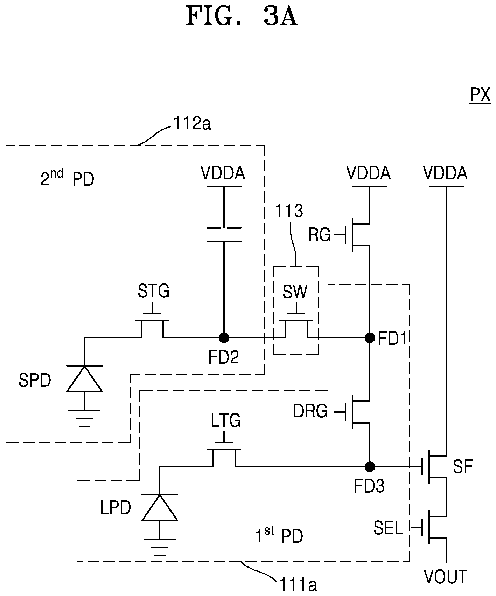

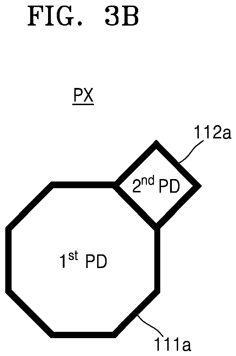

FIG. 3A is a diagram for explaining the pixel PX including the first photo diode 111a and the second photo diode 112a according to an embodiment. FIG. 3B is a diagram for explaining the pixel PX including the first photo diode 111a and the second photo diode 112a according to an embodiment.

FIGS. 3A and 3B illustrate an embodiment of one pixel PX, but the embodiment is not limited thereto, and a plurality of pixels included in a pixel array of an image sensor may also have the same structure as the embodiment of FIGS. 3A and 3B.

Referring to FIG. 3A, the pixel PX according to an embodiment may block the electrons e from moving from the first photo diode 111a to the second photo diode 112a.

The first photo diode 111a according to an embodiment may include a large photo diode LPD, a first transfer transistor LTG, the first floating diffusion node FD1, a third floating diffusion node FD3, and a gain control transistor DRG. The third floating diffusion node FD3 may be connected between the first transfer transistor LTG and the gain control transistor DRG. The first floating diffusion node FD1 may be connected between the gain control transistor DRG and the switch SW. The first photo diode 111a may be connected to the switch SW through the first floating diffusion node FD1. The second photo diode 112a according to an embodiment may include a small photo diode SPD, a second transfer transistor STG, and the second floating diffusion node FD2. The second floating diffusion node FD2 may be connected between the second transfer transistor STG and the switch SW. The second photo diode 112a may be connected to the switch SW through the second floating diffusion node FD2.

The switch SW according to an embodiment may control connection between the first floating diffusion node FD1 in the first area 111 and the second floating diffusion node FD2 in the second area 112. For example, when the first photo diode 111a is saturated, the switch SW may be opened, and the electrons e in the first area 111 may not be transferred to the second area 112. Additionally, when the second photo diode 112a is saturated, the switch SW may be opened, and the electrons e may not be transferred from the second area 112 to the first area 111. That is, the switch SW according to an embodiment may block connection between the first photo diode 111a and the second photo diode 112a which are physically isolated from each other, thereby preventing the electrons e from being transferred from the first photo diode 111a to the photo diode 112a. The image sensor according to an embodiment may reduce noise caused by a difference in sensitivity between a plurality of photo diodes, by blocking the movement of the electrons e from the first photo diode 111a to the second photo diode 112a, and by blocking the movement of the electrons e from the second photo diode 112a to the first photo diode 111a.

Referring to FIG. 3B, the pixel PX according to an embodiment may include the first photo diode 111a and the second photo diode 112a.

The size of the first photo diode 111a according to an embodiment may be greater than that of the second photo diode 112a. For example, the second photo diode 112a may be configured to have a size value less than that of the first photo diode 111a. The second photo diode 112a according to an embodiment may reach a saturation state more quickly than the first photo diode 111a. For example, the second photo diode 112a having the size less than that of the first photo diode 111a may reach the saturation state more quickly due to the same amount of light charges. The saturation state according to an embodiment means a state in which a photo diode accommodates the maximum amount of light charges. For example, when the first photo diode 111a and the second photo diode 112a each reach the saturation state, the first photo diode 111a and the second photo diode 112a may no longer accommodate light charges.

For example, in a low-illuminance situation, the first photo diode 111a may be firstly saturated, and in a high-illuminance situation, the second photo diode 111b may be firstly saturated. Electrons e may be emitted from the first photo diode 111a or the second photo diode 111b that is firstly saturated according to an embodiment. The switch SW in FIG. 3A may block the movement of electrons e from the first photo diode 111a to the second photo diode 112a or from the second photo diode 112a to the first photo diode 111a.

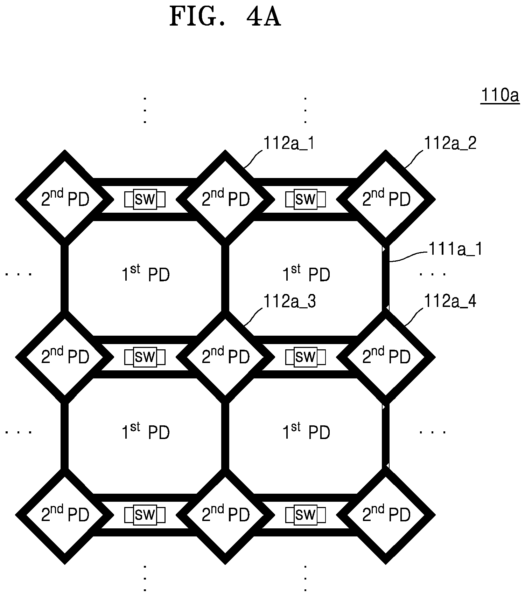

FIGS. 4A to 4C are diagrams for explaining available forms of the pixel PX including photo diodes according to an embodiment.

Referring to FIG. 4A, a first photo diode and a second photo diode of the pixel PX according to an embodiment may have a 1:1 correspondence. However, in a pixel array 110a according to an embodiment, pixels may be arranged consecutively. For example, the pixel array 110a may include a plurality of second photo diodes 112a_1, 112a_2, 112a_3, and 112a_4 with respect to one first photo diode 111a_1. Here, a large photo diode included in one pixel may be one first photo diode 111a_1, and a small photo diode may be one second photo diode 112a_1. Hereinafter, the embodiment of FIG. 4A including the first photo diode 111a_1 and the second photo diode 112a_1 included in a first pixel is described. In Fig. 4A, the photo diodes can be positioned in various directions. For example, the first direction can mean the direction from 112a_1 to 112a_2, and the second direction can mean the direction from 111a_1 to the first PD below 111a_1.

The switch SW according to an embodiment may be installed in a space isolated from the first photo diode 111a_1 and the second photo diode 112a_1 and block electrons e saturated in the first photo diode 111a_1 from being moved to the second photo diode 112a_1. The isolated space according to an embodiment may be the third area 113 of FIG. 2. The first photo diode 111a_1 and the plurality of second photo diodes 112a_1, 112a_2, 112a_3, and 112a_4 according to an embodiment may be separated from each other by a DTI.

For example, the switch SW may be in a separate space spaced apart from the first photo diode 111a_1 and the plurality of second photo diodes 112a_1, 112a_2, 112a_3, and 112a_4, and prevent electrons e from being moved the first photo diode 111a_1 to the second photo diode 112a_1. In the embodiment of FIG. 4A, the first photo diode 111a_1 and the second photo diode 112a_1 of the first pixel are mainly described, but movement of electrons e from the large photo diode to the small photo diode may be blocked by the switch SW present in each of the plurality of pixels included in the pixel array 110a.

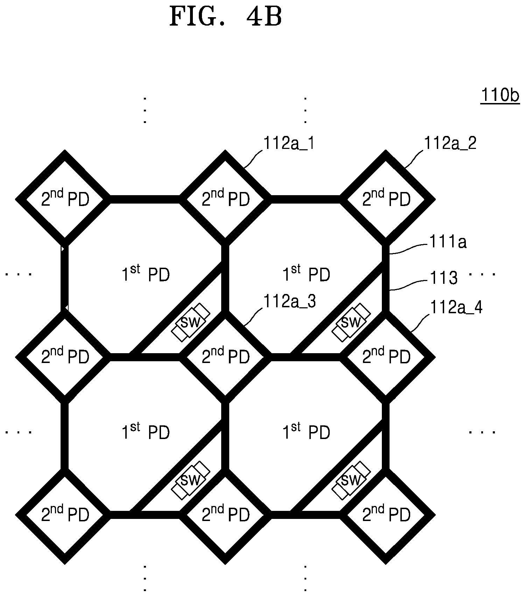

Referring to FIGS. 1 and 4B, like the embodiment of FIG. 4A, a first photo diode and a second photo diode of the pixel PX may have a 1:1 correspondence. However, a pixel array 110b according to an embodiment may include a plurality of pixels arranged consecutively. For example, the pixel array 110b may include the plurality of second photo diodes 112a_1, 112a_2, 112a_3, and 112a_4 with respect to the first photo diode 111a. The first photo diode 111a according to an embodiment may correspond to the second photo diode 112a_1 of the first pixel. Hereinafter, the embodiment of FIG. 4B including the first photo diode 111a and the second photo diode 112 a_1 included in a first pixel is described. The switch SW according to an embodiment may be installed inside a space where the first photo diode 111a exists and block electrons e from moving from the first photo diode 111a to the plurality of second photo diodes 112a_1, 112a_2, 112a_3, and 112a_4. The first photo diode 111a and the plurality of second photo diodes 112a_1, 112a_2, 112a_3, and 112a_4 according to an embodiment may be separated from each other by the DTI. The space where the switch SW according to an embodiment is isolated may be the third area 113.

For example, the switch SW may be in a separate space spaced apart from the first photo diode 111a and the plurality of second photo diodes 112a_1, 112a_2, 112a_3, and 112a_4, and prevent electrons e from being moved from the first photo diode 111a to the second photo diode 112a_1. In the embodiment of FIG. 4B, the first photo diode 111a and the second photo diode 112a_1 of the first pixel are mainly described, but the movement of electrons e from the large photo diode to the small photo diode may be blocked by the switch SW present in each of the plurality of pixels included in the pixel array 110b.

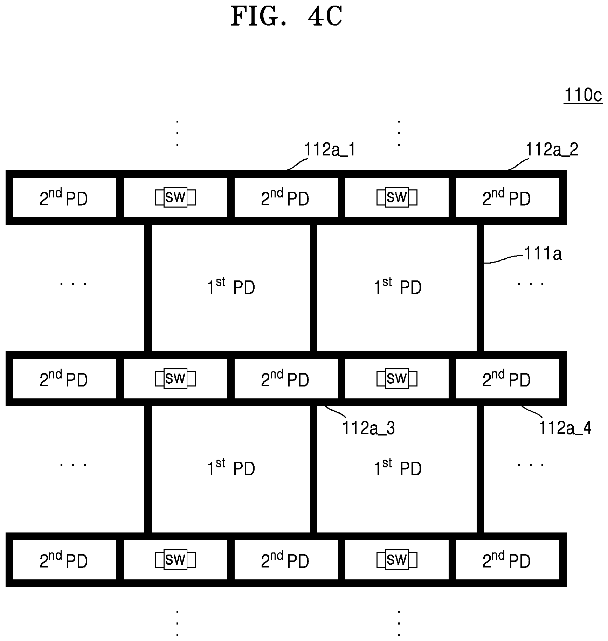

Referring to FIGS. 1 and 4C, like the embodiment of FIGS. 4A and 4B, a first photo diode and a second photo diode of the pixel PX may have a 1:1 correspondence. However, a pixel array 110c according to an embodiment may include a plurality of pixels arranged consecutively. For example, the pixel array 110c may include the plurality of second photo diodes 112a_1, 112a_2, 112a_3, and 112a_4 with respect to the first photo diode 111a. The first photo diode 111a of a first pixel according to an embodiment may be the second photo diode 112a_1 of the first pixel. Hereinafter, the embodiment of FIG. 4C including the first photo diode 111a and the second photo diode 112 a_1 included in a first pixel is described.

The switch SW according to an embodiment may be installed in a space isolated from the first photo diode 111a and the plurality of second photo diodes 112a_1, 112a_2, 112a_3, and 112a_4 to block electrons e from moving from the first photo diode 111a to the plurality of second photo diodes 112a_1, 112a_2, 112a_3, and 112a_4. The first photo diode 111a and the plurality of second photo diodes 112a_1, 112a_2, 112a_3, and 112a_4 according to an embodiment may be separated from each other by the DTI. For example, the switch SW may be in a separate space spaced apart from the first photo diode 111a and the plurality of second photo diodes 112a_1, 112a_2, 112a_3, and 112a_4, and prevent electrons e from being moved from the first photo diode 111a to the second photo diode 112a_1. In the embodiment of FIG. 4C, the first photo diode 111a and the second photo diode 112a_1 of the first pixel are mainly described, but the movement of electrons e from the large photo diode to the small photo diode may be blocked by the switch SW present in each of the plurality of pixels included in the pixel array 110c.

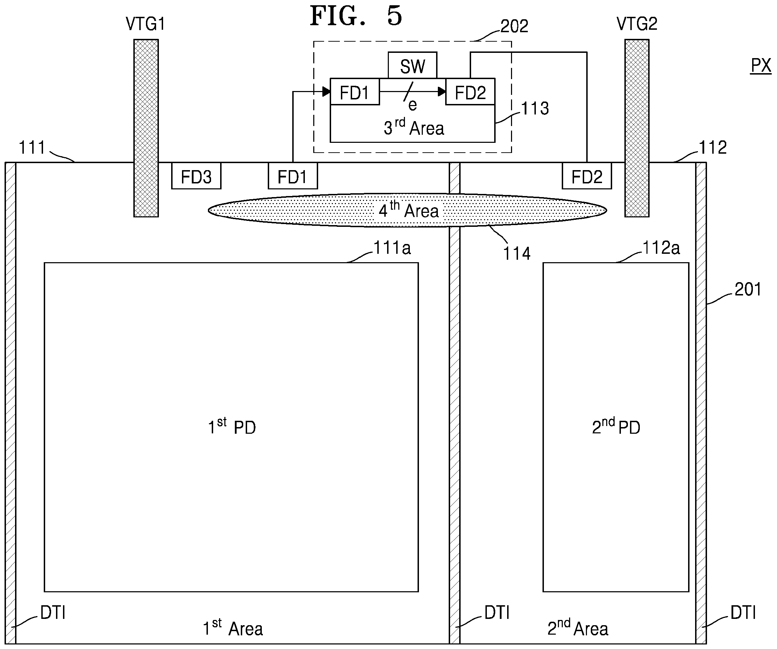

FIG. 5 is a diagram for explaining the pixel PX when the third area 113 exists in a second stack 202 according to an embodiment.

Referring to FIG. 5, the pixel PX according to an embodiment may include a first stack 201 and the second stack 202. The first stack 201 according to an embodiment may include the first area 111 and the second area 112, and the second stack 202 may include the third area 113. In this case, a further deep trench may be disposed between the first photo diode 111a and the switch SW. The further deep trench isolation may be disposed between the first PD and the switch in the plan view. The further deep trench isolation may be in contact with the first surface of the substrate and the second surface of the substrate.

In the embodiment of FIG. 5, configurations of the first area 111, the second area 112, and the fourth area 114 are the same as those of the embodiment of FIG. 2, and thus, the differences therebetween are mainly described.
Referring to FIG. 5, the third area 113 according to an embodiment may be configured to electrically connect the first floating diffusion node FD1 of the first area 111 to the second floating diffusion node FD2 of the second area 112 in the second stack 202. Unlike the embodiment of FIG. 2, the pixel PX according to the embodiment of FIG. 5 may be configured such that the first area 111 and the second area 112 are included in the first stack 201, and the third area 111 blocks connection between the first floating diffusion node FD1 of the first area 111 and the second floating diffusion node FD2 of the second area 112 in the second stack 202. The first stack 201 according to an embodiment may be a lower silicon area of the pixel PX, and the second stack 202 may be an upper silicon area. The third area 113 may be configured to electrically connect the first floating diffusion node FD1 of the first area 111 to the second floating diffusion node FD2 of the second area 112 in the second stack 202. As shown in Fig. 5, a portion of the switch SW vertically overlapping with the first photodiode 111a may be less than 50% of a whole area of the switch SW in the plan view.

The third area 113 according to an embodiment may be in a physically separate space rather than the DTI, thereby controlling the connection between the first area 111 and the second area 112. The third area 113 according to an embodiment may be configured to exist outside a stack including the first area 111 and the second area 112, and include the first floating diffusion node FD1 and the second floating diffusion node FD2. The third area 113 according to an embodiment may block connection of the switch SW outside the stack including the first area 111 and the second area 112, thereby isolating the first area 111 and the second area 112.

When the third area 113 according to an embodiment is outside the stack including the first area 111 and the second area 112, the fourth area 114 may be configured to exist across the first area 111 and the second area 112 and may prevent electrons e from being transferred from the first area 111 to the second area 112.

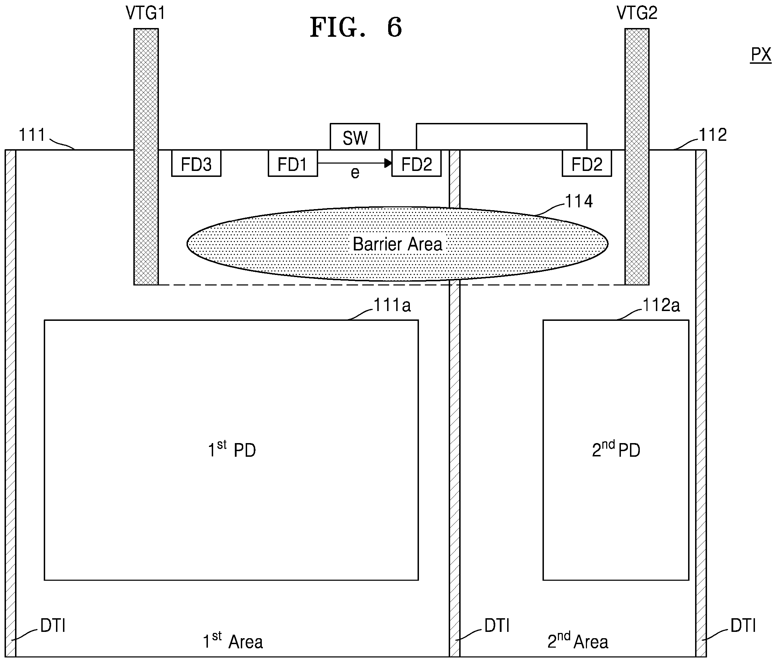

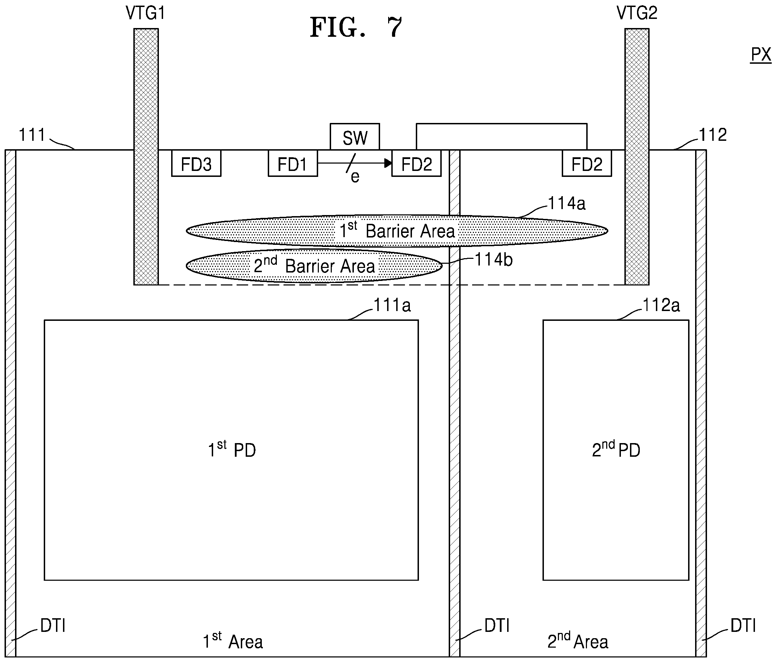

FIG. 6 is a diagram for explaining the pixel PX including an impurity area 114 according to an embodiment. FIG. 7 is a diagram for explaining the pixel PX including a plurality of impurity areas 114a and 114b according to an embodiment.

In the embodiments of FIGS. 6 and 7, configurations of the first area 111 and the second area 112 are the same as those of the embodiment of FIG. 2, and thus, the differences therebetween are mainly described. The impurity area may also be referred to as a barrier area, and hereinafter referred to as the impurity area.

The pixel PX according to an embodiment may be configured to include only the impurity area 114 and not the third area 113 of FIG. 2. The impurity area 114 according to an embodiment may have the same configuration as that of the fourth area 114 of FIG. 2. Hereinafter, in this specification, the impurity area 114 may be described as having the same configuration as that of the fourth area 114 of FIG. 2.

The first area 111 according to an embodiment may include the first photo diode 111a. In addition, the second area 112 according to an embodiment may include the second photo diode 112a having a size less than that of the first photo diode 111a. The first area 111 and the second area 112 according to an embodiment may be physically spaced apart from each other. For example, the first area 111 and the second area 112 may be physically spaced apart from each other by the DTI.

When the third area 113 of FIG. 2 or the third area 113 of FIG. 5 does not exist, the first area 111 of a corner pixel CPX according to an embodiment may include the switch SW. For example, the switch SW may be included in the first area 111 and may control connection between the first floating diffusion node FD1 and the second floating diffusion node FD2.

The impurity area 114 according to an embodiment may suppress electron transfer to the second floating diffusion node FD2. The impurity area 114 according to an embodiment may suppress electron transfer to the second floating diffusion node FD2, thereby suppressing electron transfer of the first area 111 and the second area 112. For example, the impurity area 114 may be doped with the P-type semiconductor. The impurity area 114 according to an embodiment may be doped with the P-type semiconductor, thereby suppressing movement of electrons e from the first photo diode 111a to the second floating diffusion node FD2.

The impurity area 114 according to an embodiment may be located between the first vertical structure transfer gate VTG1 and the second vertical structure transfer gate VTG2. For example, the impurity area 114 may be located between the first vertical structure transfer gate VTG1 and the second vertical structure transfer gate VTG2 and may exist across the first area 111 and the second area 112.

Referring further to FIG. 7, the corner pixel CPX according to an embodiment may include the first impurity area 114a and the second impurity area 114b.

The first impurity area 114a according to an embodiment may be located in the first area 111 and the second area 112, and may be configured to suppress movement of electrons e to the second floating diffusion node FD2. For example, the first impurity area 114a may be doped with the P-type semiconductor, and may suppress transfer of electrons e generated in the first photo diode 111a from the first floating diffusion node FD1 to the second floating diffusion node FD2, thereby suppressing movement of electrons e to the second floating diffusion node FD2 of the second area 112.

The second impurity area 114b according to an embodiment may be located in the first area 111 and may suppress movement of electrons e to the second floating diffusion node FD2. For example, the second impurity area 114b may be doped with the P-type semiconductor and may suppress transfer of electrons e generated in the first photo diode 111a to the second floating diffusion node FD2, thereby suppressing movement of electrons e from the first floating diffusion node FD1 to the second floating diffusion node FD2 of the second area 112. The second impurity area 114b may be disposed below the first impurity area 114a. For example, the depth of the second impurity area 114b may be greater than the depth of the first impurity area 114a. The depth of the first vertical structure transfer gate VTG1, the second impurity area 114b, and the second vertical structure transfer gate VTG1 may be the same.

The pixel PX according to an embodiment may include the first impurity area 114a and the second impurity area 114b, thereby suppressing movement of electrons e generated in the first photo diode 111a to the second area 112 and reducing generation of noise. The embodiment of FIG. 7 including only the first impurity area 114a and the second impurity area 114b is described, but the number of impurity areas is not limited thereto.

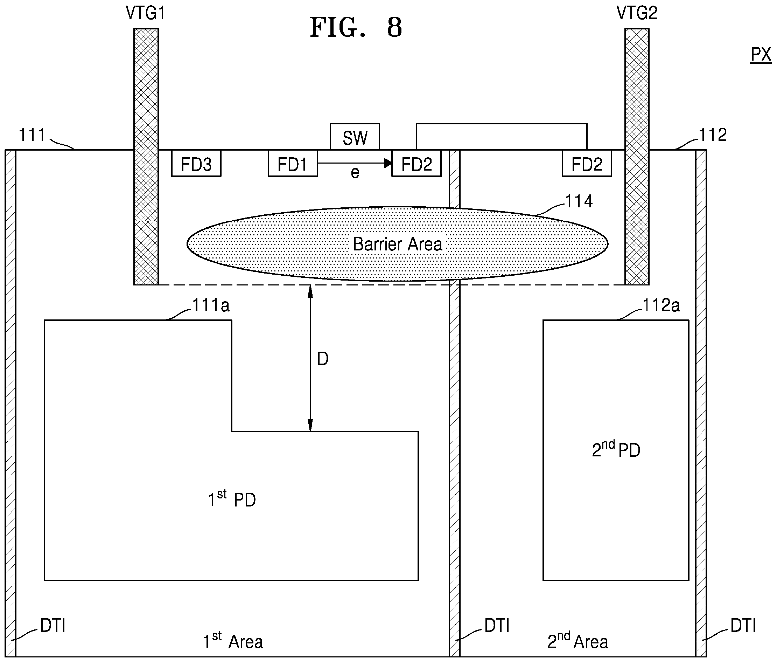

FIG. 8 is a diagram of a pixel configured with a certain distance D between a large photo diode and the impurity area 114 according to an embodiment.

In the embodiment of FIG. 8, configurations of the first area 111 and the second area 112 are the same as those of the embodiment of FIG. 3, and thus, the differences therebetween are mainly described.

Referring to FIGS. 1 and 8, the impurity area 114 according to an embodiment may be installed at the certain distance D from the first photo diode 111a. As illustrated in FIG. 8, the depth of the first vertical structure transfer gate VTG1, the impurity area 114, and the second vertical structure transfer gate VTG1 may be the same. The impurity area 114 according to an embodiment may be provided at the certain distance D from the first photo diode 111a, thereby suppressing movement of the electrons e emitted from the first photo diode 111a. For example, the impurity area 114 may be provided at the certain distance D from the first photo diode 111a, thereby preventing the electrons e emitted from the first photo diode 111a from moving to the second floating diffusion node FD2. The electrons e emitted from the first photo diode 111a may be prevented from moving to the second floating diffusion node FD2 according to an embodiment, thereby suppressing the electrons e from moving from the pixel PX to the second area 112, and preventing deterioration of the second photo diode 112a.

According to an embodiment, the impurity area 114 may be doped with a P-type semiconductor. The impurity area 114 according to an embodiment may be doped with the P-type semiconductor, thereby suppressing movement of electrons e from the first photo diode 111a to the second floating diffusion node FD2.

The certain distance D according to an embodiment may be a value determined at the time of manufacturing the pixel PX. For example, the certain distance D may be a set distance at which the electrons e emitted from the first photo diode 111a may not reach the impurity area 114 or a distance at which the electrons e has energy that may not pass through the impurity area 114 even though reaching the impurity area 114, but is not limited thereto.

While aspects of the inventive concept have been particularly shown and described with reference to embodiments thereof, it will be understood that various changes in form and details may be made therein without departing from the scope of the following claims.

### Annex A

The present invention can also be defined by reference to the following clauses:
Clause 1. An image sensor comprising:
   a substrate comprising a first surface and a second surface opposing the first surface;
   a plurality of photo diodes (PDs) disposed in a first direction and a second direction perpendicular to the first direction, the plurality of PDs including a first PD and a second PD having a size less than a size of the first PD;
   a first floating diffusion node (FD);
   a second FD;
   a third FD;
   a first switch connected to the second FD and the third FD;
   a gain control transistor connected to the first FD and the second FD;
   a first deep trench isolation separating the first PD and the second PD;
   a first transfer transistor configured to transfer photoelectric charges generated by the first PD to the first FD; and
   a second transfer transistor configured to transfer photoelectric charges generated by the second PD to the third FD,
   wherein the second PD is directly disposed diagonally from the first PD in a plan view,
   wherein a portion of the first switch vertically overlapping with the first PD is equal or greater than 0% and less than 50% of a whole area of the first switch in a plan view.
Clause 2. The image sensor of clause 1, wherein the portion of the first switch vertically overlapping with the first PD is equal or greater than 0% and less than 20% of the whole area of the first switch in the plan view.
Clause 3. The image sensor of clause 1 or clause 2, further comprising:
   a plurality of switches disposed in the first direction and the second direction.

## Claims

1. An image sensor comprising:
a substrate comprising a first surface and a second surface opposing the first surface;
a first area comprising a first floating diffusion node (FD), a second FD, and a first photo diode (PD);
a second area comprising a third FD and a second PD having a size less than a size of the first PD;
a switch connected to the second FD and the third FD;
a gain control transistor connected to the first FD and the second FD;
a first deep trench isolation separating the first PD and the second PD;
a first transfer transistor configured to transfer photoelectric charges generated by the first PD to the first FD; and
a second transfer transistor configured to transfer photoelectric charges generated by the second PD to the third FD,
wherein a portion of the switch vertically overlapping with the first PD is equal or greater than 0% and less than 50% of a whole area of the switch in a plan view.

2. The image sensor of claim 1, wherein the second area is directly disposed diagonally from the first area in the plan view.

3. The image sensor of claim 1 or claim 2, wherein the portion of the switch vertically overlapping with the first PD is equal or greater than 0% and less than 20% of the whole area of the switch in the plan view.

4. The image sensor of any preceding claim, wherein the switch is disposed between the first PD and the second PD in the plan view.

5. The image sensor of any preceding claim, further comprising:
a third area comprising a fourth FD and a third PD having a size less than the size of the first PD,
wherein the third area is disposed adjacent to the second area in a first direction, and
wherein the switch is disposed between the second PD and the third PD in the plan view.

6. The image sensor of any of claims 1 to 4, further comprising:
a third area comprising a fourth FD and a third PD having substantially the same size as the size of the first PD,
wherein the third area is disposed adjacent to the first area in a second direction, and
wherein the switch is disposed between the first PD and the third PD in the plan view.

7. The image sensor of any preceding claim, further comprising:
a second deep trench isolation,
wherein the second deep trench isolation is disposed between the first PD and the switch in the plan view.

8. The image sensor of any preceding claim, wherein the first deep trench isolation is in contact with the first surface of the substrate and the second surface of the substrate.

9. The image sensor of any preceding claim, wherein the first transfer transistor is extended into the substrate.

10. The image sensor of any preceding claim, further comprising:
a second deep trench isolation,
wherein the second deep trench isolation is disposed between the first PD and the switch in the plan view, and
wherein the second deep trench isolation is in contact with the first surface of the substrate and the second surface of the substrate.

11. The image sensor of any preceding claim, further comprising:
a barrier area doped with a P-type semiconductor,
wherein the barrier area is disposed between the switch and the first PD in the plan view.

12. The image sensor of claim 11, wherein a vertical distance between the barrier area and the first PD in the plan view is equal to or greater than a preset distance.

13. An image sensor as claimed in any preceding claim, the image sensor comprising:
a plurality of photo diodes (PDs) disposed in a first direction and a second direction perpendicular to the first direction, the plurality of PDs including a first PD and a second PD having a size less than a size of the first PD,
wherein the second PD is directly disposed diagonally from the first PD in a plan view.

14. The image sensor of claim 13, wherein the portion of the first switch vertically overlapping with the first PD is equal or greater than 0% and less than 20% of the whole area of the first switch in the plan view.

15. The image sensor of claim 13 or claim 14, further comprising:
a plurality of switches disposed in the first direction and the second direction.
